# EUROPÄISCHE PATENTSCHRIFT

(11) **EP 2 170 762 B1**
(45) Veröffentlichungstag und Bekanntmachung des Hinweises auf die Patenterteilung: **20.09.2017**
(21) Anmeldenummer: 08774477.7
(22) Anmeldetag: 27.06.2008
(51) Int. Cl.: B81B 7/00, G01N 11/16

(54) **KORROSIONSBESTÄNDIGES MEMS-BAUELEMENT UND VERFAHREN ZU SEINER HERSTELLUNG**
CORROSION-RESISTANT MEMS COMPONENT, AND METHOD FOR THE PRODUCTION THEREOF
COMPOSANT MEMS RÉSISTANT À LA CORROSION ET SON PROCÉDÉ DE RÉALISATION

(30) Priorität: 29.06.2007 DE 102007031128
(43) Veröffentlichungstag der Anmeldung: 07.04.2010
(73) Patentinhaber: IHP GmbH-Innovations for High Performance Microelectronics / Leibniz-Institut für innovative Mikroelektronik, 15236 Frankfurt / Oder (DE)
(72) Erfinder: DREWS, Jürgen, 15230 Frankfurt (Oder) (DE); EHWALD, Karl-Ernst, 15234 Frankfurt (Oder) (DE); SCHULZ, Katrin, 15236 Frankfurt (Oder) (DE)
(74) Vertreter: Eisenführ Speiser
(86) Internationale Anmeldenummer: PCT/EP2008/058316
(87) Internationale Veröffentlichungsnummer: WO 2009/003958

(56) Entgegenhaltungen:
- WO-A-2005/054817
- DE-A1- 10 027 684
- DE-B3-102005 016 243
- US-A1- 2003 124 462

## Beschreibung

Die Erfindung betrifft eine mikroelektromechanische (MEMS-)Struktur, insbesondere einen in korrosiven Gasen oder Flüssigkeiten mit beispielsweise hoher Salzkonzentration arbeitsfähigen Sensor, der in einer speziellen Ausführungsform ein Sensor für ein Mikroviskosimeter sein kann. Die Erfindung betrifft weiterhin ein Verfahren zur Herstellung einer solchen Struktur, eines solchen Sensors und insbesondere eines Mikroviskosimeters.

Aus der DE 100 27 684 B4 ist eine Vorrichtung und ein Verfahren zur Viskositätsmessung bekannt. Nachfolgend wird zunächst das Arbeitsprinzip des dort beschriebenen Viskosimeters kurz erläutert.

In einer Messzone auf einem mechanisch stabilen Substrat sind zwei oder mehrere in geringem Abstand angeordnete Leiter angeordnet, von denen mindestens einer an eine gesteuerte Stromquelle oder an eine HF-Spannungsquelle angeschlossen ist. Ein zweiter Leiter, hier auch als Aktuator bezeichnet, ist innerhalb der Messzone gänzlich oder streckenweise freitragend gehaltert. Eine zur elastischen Verbiegung desselben erforderliche Kraft wird durch ein Hochfrequenzfeld zwischen dem Aktuator und einem unter diesem angeordneten Leitbahngebiet erzeugt, das auch als Grundplatte bezeichnet wird, wobei die Frequenz des Hochfrequenzfeldes um ein Vielfaches höher ist als die Eigenresonanzfrequenz der Anordnung.

Die Lage des freitragend gehaltenen Aktuators innerhalb der Messzone kann unter Ausnutzung der Elastizität seiner Halterung oder unter Ausnutzung seiner eigenen Elastizität durch spannungsabhängige oder stromabhängige elektrische oder magnetische Anziehungs- oder Abstoßungskräfte verändert werden. Diese Kräfte werden zeitlich mittels der HF-Spannungsquellen oder Stromquellen verändert.

Die Kapazität der Anordnung aus Aktuator, Grundplatte und einem den Raum zwischen diesen ausfüllenden Medium ist ein Maß für die elastische Verbiegung des Aktuators durch die elektrische Anziehungskraft des besagten elektrischen Hochfrequenzfeldes. Diese Kapazität und beeinflusst rückwirkend die Oszillatorfrequenz, da sie ein integrierter Bestandteil des das Hochfrequenzfeld erzeugenden LC- oder Ringoszillators ist.

Durch Veränderung der Anziehungs- oder Abstoßungskräfte und durch in Abhängigkeit von der Viskosität des zu untersuchenden Mediums verzögerte Lageveränderung des Aktuators kann mit Hilfe einer integrierten Messvorrichtung auf die Viskosität des zu untersuchenden Mediums rückgeschlossen werden. Die Viskosität einer den Raum zwischen dem Aktuator und der Grundplatte ausfüllenden Flüssigkeit kann also anhand der messbaren Zeitspanne bestimmt werden, welche nach dem Einschalten des Oszillators für eine vorgegebene Frequenzverstimmung desselben bezogen auf seine Startfrequenz erforderlich ist.

Nachfolgend werden strukturelle Merkmale der aus der DE 100 27 684 B4 bekannten Vorrichtung und die Prozesstechnik für Ihre Herstellung kurz erläutert.

Der Aktuator soll aus einem sehr dünnen, elastischen und vorzugsweise oberflächlich isolierten oder passivierten Material bestehen. Als Beispiel ist passiviertes Aluminium genannt. Eine bewegliche Leiterschleife aus Aluminium wird nach Fertigstellung aller aktiven und passiven Komponenten einer integrierten Schaltung des Viskositätssensors dadurch erzeugt, dass vor der Öffnung von Passi-vierungsfenstern und vor der Vereinzelung der auf einem Wafer produzierten Sensorchips eine zusätzliche photolithographisch strukturierte Lackmaske aufgebracht wird. Mit ihrer Hilfe wird der für die bewegliche Leiterschleife vorgesehene Teil der obersten Leitbahnebene der integrierten Schaltung durch einen lokalen, isotropen Isolatorätzprozess unterätzt und vollständig von der isolierenden Unterlage getrennt.

Bei dem aus der DE 100 27 684 B4 bekannten Verfahren zur Herstellung des Aktuators eines Mikroviskosimeters unter Verwendung der obersten Leitbahnebene eines konventionellen Me3hrebenenleitbahnsystems ist nachteilig, dass die vorgeschlagenen verwendeten Aktuatorstrukturen aus oberflächlich isoliertem oder passiviertem Aluminium Al für Anwendungen in korrosiven Medien wie einem Blutplasma nicht dauerhaft korrosionsfest sind.

Dieses Problem trifft allgemein MEMS-Strukturen, die im Betrieb korrosiven Gasen oder Flüssigkeiten ausgesetzt sind.

Aus DE 10 2005 016 243 B3 ist ein mikromechanisches Bauelement bekannt mit einem Aktuator aus Metall, wobei das Metall in Passivierungsschichten eingebettet sein kann. Die Korrosionsfestigkeit des Aktuators hängt also von der Güte der aufgebrachten Schicht ab, bei auftretenden Rissen in der Beschichtung ist der Aktuator nicht mehr korrosionsfest.

Das der vorliegenden Erfindung zugrunde liegende technische Problem ist es daher, eine MEMS-Struktur bzw. ein MEMS-Bauelement wie beispielsweise einen Sensor, etwa ein Mikroviskosimeter anzugeben, das besonders beständig in einem korrosiven Medium ist und zugleich mit einem konventionellen Ba-ckend-Prozess herstellbar ist. Unter Verfahrensgesichtspunkten liegt der Erfindung das technische Problem zugrunde, ein Verfahren zur Herstellung eines solchen MEMS-Bauelements anzugeben.

Gemäß einem ersten Aspekt der Erfindung wird das eine Vorrichtung betreffende technische Problem durch ein MEMS-Bauelement gemäß Anspruch 1 gelöst.

Das erfindungsgemäße MEMS-Bauelement umfasst ein monolithisch integriertes elektronisches Bauelement mit einem auf einem Substrat angeordneten Mehrebenen-Leitbahnschichtstapel. In den Mehrebenen-Leitbahnschichtstapel ist ein frei tragender, elastisch beweglicher, metallischer Aktuator integriert, der im Mehrebenen-Leitbahnschichtstapel auf Höhe einer Leitbahnebene angeordnet ist und durch Viakontakte mit darüber oder darunter angeordneten Leitbahnebenen verbunden ist. Die Leitbahnebenen sind, abgesehen von einer Ausnehmung im Bereich des Aktuators, durch eine jeweilige Zwischenebenenisolatorschicht von der Leitbahnebene des Aktuators getrennt. Der Aktuator ist aus einer metallisch leitfähigen und gegenüber korrosiven Flüssigkeiten beständigen leitenden Schicht oder Schichtkombination gebildet. Die Aktuatorschicht besteht aus Titannitrid.

Der Aktuator ist an wenigstens zwei einander gegenüberliegenden Aufhängepunkten am Rande der Ausnehmung fest in der Zwi-schenebenenisolatorschicht verankert. Er weist hierbei eine spiegelsymmetrische Lateralstruktur mit wenigstens zwei zur Verbindungslinie zwischen den Aufhängepunkten senkrecht stehenden Leitbahnabschnitten in der Nähe einer Symmetrieachse der Ausnehmung auf.

Das erfindungsgemäße MEMS-Bauelement hat den Vorteil, dass das für den Aktuator und für die Grundplatte verwendete Material Titannitrid in korrosiven Medien besonders stabil ist und zugleich mit einem üblichen Backendprozess zur Herstellung mikroelektronischer Schaltungen kompatibel ist. Die erfindungsgemäße MEMS-Struktur ist daher für den Einsatz in korrosiven Gasen oder Flüssigkeiten wie beispielsweise Kochsalzlösungen oder Blutplasma oder in anderen Flüssigkeiten, die solche korrosiven Komponenten enthalten, besonders geeignet. Gleichzeitig ist es mit bekannten Standardprozessen kostengünstig herstellbar.

Die Geometrie des Aktuators erlaubt eine verbesserte Dehnbarkeit des Aktuators in Richtung der Verbindungslinie zwischen den Aufhängepunkten. Es gelingt so einerseits, eine hinreichende Verbiegung, also eine hinreichende Kapazitätsänderung, bei einer HF-Spannung von weniger als 1V zu ermöglichen, ohne eine unkontrollierte Anfangsverbiegung der Aktuatorstruktur in Folge mechanischer Spannungen innerhalb der dünnen Aktuatorschicht in Kauf nehmen zu müssen. Die im Falle starker innerer Spannungen unvermeidlichen Verbiegungen von Teilen dieser Aktuatorstruktur senkrecht zur Leitbahnebene führen bei der beschriebenen Struktur zu einer weiteren Verbesserung der Dehnbarkeit des Aktuators in Richtung der Verbindungslinie zwischen den Aufhängepunkten.

Üblicherweise werden in der Mikrosystemtechnik mikromechanisch arbeitende Kantilever und andere Aktuatoren aus einkristallinem Silizium oder Polysilizium hergestellt. Diese Materialien sind für eine MEMS-Struktur wie beispielsweise ein Mikroviskosimeter bei einer Arbeitsfrequenz des Oszillators von einigen GHz unter anderem wegen des zu hohen Schichtwiderstandes und aus Gründen der schwierigen Integration des Herstellungsprozesses in einen CMOS-Standardablauf nicht geeignet.

Korrosionsbeständige Edelmetalle wie Au, Ag, Pt usw. werden zwar in der Mikrosystemtechnik teilweise eingesetzt, sind aber mit einem konventionellen Backend-Prozess für integrierte Schaltungen nicht ohne weiteres kompatibel.

Das erfindungsgemäße MEMS-Bauelement verwendet dagegen zur Realisierung des Aktuators eine aus Titannitrid bestehende Schicht. Eine nur aus Titannitrid bestehende Leitbahnebene kommt wegen des höheren elektrischen Widerstandes von Titannitrid im Vergleich mit üblichen Leitbahnmaterialien wie Aluminium-Kupfer (AlCu) oder Kupfer (Cu) nicht für normale Schaltungsanwendungen in Frage. Jedoch erfüllt dünnes Titannitrid im Dickenbereich zwischen 40 und 100 nm die Anforderung, mit einem konventionellen Backend-Prozess vollständig kompatibel zu sein, da es Bestandteil der typischerweise in einem AlCu-Backend verwendeten Leitbahnstapel ist.

Das erfindungsgemäße MEMS-Bauelement hat weitere Vorteile, die nachfolgend erläutert werden.

Die Verwendung von dünnem Titannitrid im o. g. Dickenbereich erlaubt bei einem bezüglich Kapazität und Leistungsverbrauch eines Oszillors optimierten Layout eine elastische Verbiegung des Aktuators von einigen µm bereits bei einer HF-Effektivspannung von ca. 1 V. Im konkreten Anwendungsbeispiel eines Mikroviskosimeters ist dieses Maß der Verbiegung für eine hinreichend genaue Viskositätsmessung erforderlich.

Die elastisch aufgehängte Aktuatoranordnung unter Verwendung von Titantnitrid ist weiterhin nach dem Freiätzen mechanisch besonders stabil, z.B. gegenüber den Prozessen zur Reinigung bzw. Resistentfernung während der Herstellung des erfindungsgemäßen MEMS-Bauelements.

Die Ausbildung des erfindungsgemäßen MEMS-Bauelements im Mehrebenen-Leitbahnschichtstapel des integrierten elektronischen Bauelements erlaubt es, durch Auswahl einer geeigneten Leitbahnebene für den Aktuator und für die Grundplatte einen für eine bestimmte Anwendung optimalen Abstand zwischen
dem elastisch beweglichen Aktuator und der Grundplatte einzustellen. Der Abstand ist durch die Summe der Dicken der dazwischenliegenden Zwischenebenenisolatorschichten einstellbar.

Das MEMS-Bauelement der Erfindung kann in vielen Anwendungen Verwendung finden. Die im Mehrebenen-Leitbahnschichtstapel ausgebildetete MEMS-Struktur des erfindungsgemäßen MEMS-Bauelements ist zwar insbesondere zur Verwendung in einem MEMS-Resonator geeignet. Jedoch ist dies nicht nicht als Beschränkung zu verstehen. Die MEMS-Struktur kann in anderen Ausführungsbeispielen für die technische Ausnutzung anderer physikalischer Effekte Verwendung finden. Sie kann beispielsweise in einem thermoelektrischen Messverfahren Anwendung finden. So kann die Aktuatorschicht beispielsweise zur Bereitstellung eines temperaturabhängigen elektrischen Widerstands verwendet werden. Dies kann im Zusammenhang mit der Messung eines Gasdrucks technisch genutzt werden, wie es in der DE 10 2005 055 083 A1 beschrieben ist. Der Begriff "Aktuatorschicht" bzw. "Aktuator" ist also im Rahmen der vorliegenden Anmeldung so zu verstehen, dass er einen Aktuator einer Resonatorstruktur als bevorzugte Ausführungsform umfasst, jedoch nicht darauf beschränkt ist.

Nachfolgend werden Ausführungsbeispiele des erfindungsgemäßen MEMS-Bauelements beschrieben. Die zusätzlichen Merkmale der Ausführungsbeispiele können zur Bildung weiterer Ausführungsformen miteinander kombiniert werden, es sei denn, sie sind in der Beschreibung ausdrücklich als Alternativen zueinander beschrieben.

Bei einem Ausführungsbeispiel des erfindungsgemäßen MEMS-Bauelements bildet eine korrosionsfeste und metallisch leitfähige Grundplatte eine Gegenelektrode des Aktuators. Die Grundplatte wird bevorzugt von einem mit Titannitrid bedeckten Leitbahngebiet einer Leitbahnebene der Mehrebenen-Leitbahnschichtstapels oder aus einem hochdotierten Gebiet des Halbleitersubstrates gebildet.

Bei einem Ausführungsbeispiel des MEMS-Bauelements der vorliegenden Erfindung wird der Aktuator von einer TiN-Schicht mit einer Dicke zwischen 40 und 100 nm auf Höhe der dritten Leitbahnebene eine 4-Ebenen-Leitbahnsystems gebildet.

In einem weiteren Ausführungsbeispiel sind auf der Leitbahnebene des Aktuators Leitbahnstrukturen angeordnet, die die Aktuatorschicht als Teil enthalten. Auf diese Weise können weitere Schichten der Leitbahnstrukturen zur Optimierung der Leitfähigkeit verwendet werden, während diese im Bereich der Aktuatorsstruktur selektiv entfernt sind. Die Entfernung erfolgt verfahrenstechnisch vorzugsweise im gleichen Schritt wie die Ätzung der Zwischenebenen-Isolatorschichten, ist aber auch mittels eines separaten Maskierungsschrittes vor oder nach der Strukturierung der betreffenden Metallebene möglich Die Leitbahnen und die Grundplatte können beispielsweise aus einer Ti/TiN/AlCuTi/TiN Schichtkombination gebildet sein.

Alternativ kann die Grundplatte von einem hochdotierten, ggf. mit Metallsilizid oder Titannitrid bedeckten aktiven Gebiet eines Halbleitersubstrats gebildet werden, auf dem der Mehrebenen-Leitbahnschichtstapel angeordnet ist.

Die beschriebenen Vorteile der Erfindung können in verschiedenen Anwendungsfällen genutzt werden. Ein derzeit bevorzugtes Anwendungsfeld des erfindungsgemäßen MEMS-Bauelements ist ein Mikroviskosimeter.

Gemäß einem zweiten Aspekt der Erfindung wird das ein Verfahren betreffende Problem durch ein Herstellungsverfahren für ein MEMS-Bauelement nach Anspruch 8 gelöst. Das Verfahren umfasst die folgenden Schritte:
- Herstellen eines Mehrebenen-Leitbahnschichtstapels auf einem Substrat bis zur Höhe einer für einen Aktuator vorgesehenen Leitbahnebene, wobei jeweilige Leitbahnebenen aus einem metallisch leitfähigen Leitbahnmaterial durch eine jeweilige Zwischenebenenisolatorschicht getrennt werden;
- Herstellen einer metallisch leitfähigen, elastisch beweglichen und gegenüber korrosiven Flüssigkeiten beständigen Aktuatorschicht, die aus Titannitrid besteht, auf der dafür vorgesehenen Leitbahnebene;
- Herstellen einer Ausnehmung im Mehrebenen-Leitbahnschichtstapel im Bereich der Aktuatorschicht, indem durch selektives isotropes nasschemisches Ätzen mit einem Ätzmittel, vorzugsweise in Kombination mit einem vorher durchgeführten RIE-Process, mindestens eine Zwischenebeneniso-Iatorschicht zwischen dem Aktuator und dem Substrat entfernt wird, derart, dass der Aktuator frei tragend wird; und
- Kontaktieren des Aktuators durch Herstellen von Viakontakten mit darüber oder darunter angeordneten Leitbahnebenen, wobei das Herstellen der Viakontakte vor oder nach dem Herstellen der Aktuatorschicht durchgeführt wird.

Durch Verwendung von Titannitrid bei der Herstellung der Aktuatorschicht gelingt nicht nur die Erzielung der strukturellen Vorteile, die im Zusammenhang mit der Beschreibung des MEMS-Bauelements gemäß dem ersten Aspekt der Erfindung bereits erläutert wurden. Aus verfahrenstechnischer Sicht hat die Verwendung von Titannitrid in der Aktuatorschicht den weiteren Vorteil, dass das Freiätzen des Aktuators mit Hilfe eines selektiven, isotropen nass-chemischen Ätzschritts erfolgen kann. Dabei kann auf die Nutzung einer Hartmaske verzichtet werden und statt dessen eine geeignete stabilere Resistmaske verwendet werden. Eine Hartmaske beziehungsweise deren Entfernung hat den Nachteil, dass ihre Abscheidung und Entfernung die Qualität einer Passivierungsschicht auf der obersten Leitbahnebene des Mehrebenen-Leitbahnsystems beeinträchtigen kann. Dieser Nachteil wird bei dem erfindungsgemäßen Verfahren umgangen.

Die Verwendung von Titannitrid erlaubt weiterhin die Verwendung von hochselektiven Ätzmitteln.

Nachfolgend werden Ausführungsbeispiele des Verfahrens gemäß dem zweiten Aspekt der vorliegenden Erfindung beschrieben. Auch hier können die zusätzlichen Merkmale verschiedener Ausführungsbeispiele miteinander kombiniert werden, um weitere Ausführungsformen des erfindungsgemäßen Verfahrens zu bilden, es sei denn, die betreffenden Ausführungsbeispiele sind als alternative zueinander beschrieben.

Vorzugsweise erfolgt das Herstellen der Ausnehmung im Mehrebenen-Leitbahnschichtstapel erst nach einer Komplettierung des Mehrebenen-Leitbahnschichtstapels bis einschließlich einer Herstellung einer Passivierungsschicht einer höchsten Leitbahnebene.

Das Ätzmittel, welches zum Herstellen der Ausnehmung im Mehrebenen-Leitbahnschichtstapel im Bereich der Aktuatorschicht verwendet wird, enthält in einem Ausführungsbeispiel vorteilhafterweise Ethylenglycol, Wasser, Amoniumfluorid und Flusssäure. In einer Ausführungsform besteht das Ätzmittel aus diesen Komponenten in einer geeigneten Zusammensetzung. Dieses Ätzmittel hat den Vorteil, dass es eine Ätzung von typischer Weise verwendeten Zwischenebenen-Isolatorschichten aus SiOₛ, SiON oder SiN hochselektiv zu Metallen ätzt. Die gewünscht hohe Selektivität dieses Ätzmittels besteht beispielsweise gegenüber Aluminium, Aluminium/Kupfer, Titan, Wolfram, weiterhin gegenüber Titannitrid und Metalllegierungen wie Cobaltsilizid, Titansilizid und Platinsilizid.

In einem weiteren Ausführungsbeispiel erfolgt beim Herstellen der Ausnehmung die Entfernung der mindestens eine Zwischenebenen-Isolatorschicht unter Verwendung einer Fotolackmaske oder unter Verwendung einer Kombination einer Fotolackmaske mit einer Hartmaske. In letzterem Falle kann die Hartmaske Bestandteil des Passivierungsstapels sein und muss im Gegensatz zu üblichen Hartmasken nicht nach der Ätzung selektiv wieder entfernt werden, was im Backend schwer realisierbar ist. Die Hartmaske wird über die Fotolackmaske strukturiert (mit einem nasschemischen Ätzmittel oder plasmachemisch). Danach verbleibt die Fotolackmaske während der Ätzung auf der Hartmaske und wird erst danach entfernt. Dadurch wird die Anforderung an die Ätzbeständigkeit der Hartmaske reduziert.

Bei einer nass-chemischen Ätzung der im Backend verwendeten und in typischer Weise mehrere Mikrometer starken Zwischenebenen-Isolatorschichten über eine Fotolackmaske ist deren Ätzstabilität von besonderer Bedeutung. Dies wird in einem Ausführungsbeispiel durch die Verwendung einer Kombination von Lackhaftvermittlern zur Erhöhung der Haftfestigkeit des Photolacks erreicht. Nach Ätzung der mindestens einen Zwischenebenen-Isolatorschicht wird die Fotolackmaske in geeigneter Weise mittels polarer Lösungsmittel entfernt. Beispiele geeigneter Lösungsmittel sind Aceton und Isopropanol oder eine Kombination dieser Lösungsmittel.

Wichtig ist es, in einem anschließenden Trocknungsprozess zur Beseitigung des Lösungsmittels einen so genannten "Sticktion-Effekt" und damit eine plastische Verformung der Aktuatorstruktur zu vermeiden. Dies gelingt in einem Ausführungsbeispiel, bei dem die Lösungsmittel in einem Trocknungsprozess durch Cyclohexan verdrängt werden, welches mittels Kühlung in den festen Aggregatzustand überführt und über einen Gefriertrocknungsprozess entfernt wird.. Eine alternative Methode ist es, das Lösungsmittel zur Entfernung der Fotolackmaske mittels flüssigem Kohlendioxid zu entfernen. In einer Ausführungsform wird dabei das Kohlendioxid durch Erhöhen der Temperatur auf einen Wert über 32°C und des Erhöhen Druckes auf einen Wert über 74 bar in einen superkritischen Zustand gebracht. Nach Entfernen des Lösungsmittels zur Entfernung der Fotolackmaske wird auch das hierzu verwendete Kohlendioxid entfernt, ohne dass die Aktuator-Struktur plastisch verformt wird. Auch bei dieser alternativen Ausführungsform des Trocknungsprozesses gelingt eine Entfernung des Lösungsmittels ohne plastische Verformung des Aktuators.

Weitere Ausführungsbeispiele sind in den abhängigen Ansprüchen definiert. Nachfolgend wird die Erfindung an Hand zusätzlicher Ausführungsbeispiele erläutert. Es zeigen:
- Fig. 1: eine schematischer Querschnittsansicht eines MEMS-Bauelements am Beispiel eines Mikroviskosimeters in einer ersten Querschnittsebene;
- Fig. 2: eine schematische Querschnittsansicht des MEMS-Bauelements der Fig. 1 in einer zur Querschnittsebene der Fig. 1 senkrechten Schnittebene;
- Fig. 3: eine Draufsicht einer Aktuatorstruktur gemäß einem weiteren Ausführungsbeispiel der Erfindung;
- Fig. 4: eine Draufsicht einer weiteren Aktuatorstruktur einem anderen Ausführungsbeispiel der Erfindung; und
- Fig. 5: ein Flussdiagramm eines Ausführungsbeispiels eines Herstellungsverfahrens für ein MEMS-Bauelement.

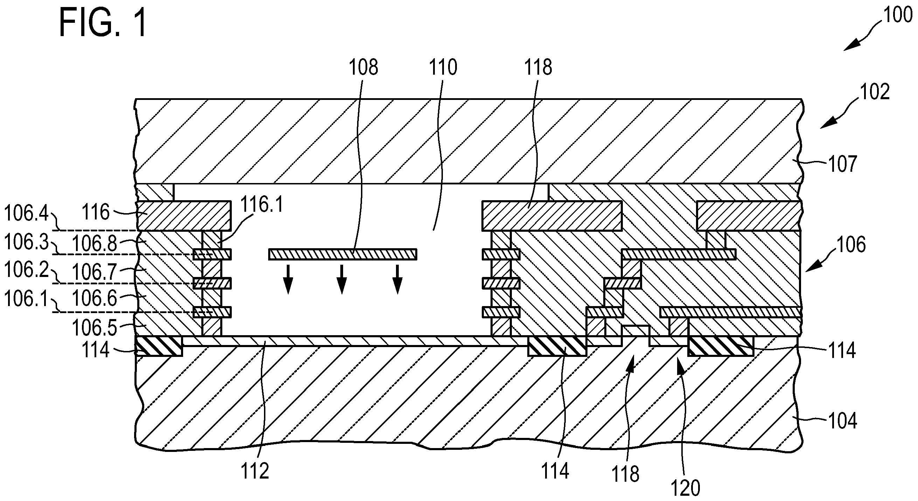

Figur 1 zeigt eine vereinfachte Querschnittsansicht eines MEMS-Bauelements am Beispiel eines MEMS-Resonators für ein Mikroviskosimeter 100. Das Beispiel eines Mikroviskosimeters stellt einen derzeit besonders beachteten Anwendungsfall des MEMS-Bauelements der vorliegenden Erfindung dar. Es ist jedoch nicht als die Erfindung einschränkend zu verstehen. Das MEMS-Bauelement kann auch in anderen Anwendungszusammenhängen Verwendung finden. Insbesondere ist es dort besonders geeignet, wo das MEMS-Bauelement einem korrosiven Medium ausgesetzt wird. Ein korrosives Medium ist beispielsweise oft bei der Erfassung von klimatischen Umgebungsparametern (Gasdruck, relative Feuchte, Taupunkt, Temperatur) gegeben, insbesondere in Produktionsumgebungen, aber beispielsweise auch bei die Messung der Luftfeuchtigkeit am Meer.

Das Mikroviskosimeter enthält ein monolithisch integriertes elektronisches Bauelement 102, welches auf einem Siliziumsubstrat 104 einen Mehrebenen-Leitbahnschichtstapel 106 umfasst, welcher von einer semipermeablen Membran 108 bedeckt ist.

In den Mehrebenen-Leitbahnschichtstapel 106 ist ein Aktuator 108 integriert. Der Aktuator ist im Mehrebenen-Leitbahnschichtstapel 106 auf Höhe der dritten Leitbahnebene 106.3, gerechnet vom Siliziumsubstrat aus, angeordnet. Die vier Leitbahnebenen 106.1 bis 106.4 des Mehrebenen-Leitbahnschichtstapels 106 sind in Fig. 1 am linken Rand des Bauelements durch gestrichelte Linien angedeutet.

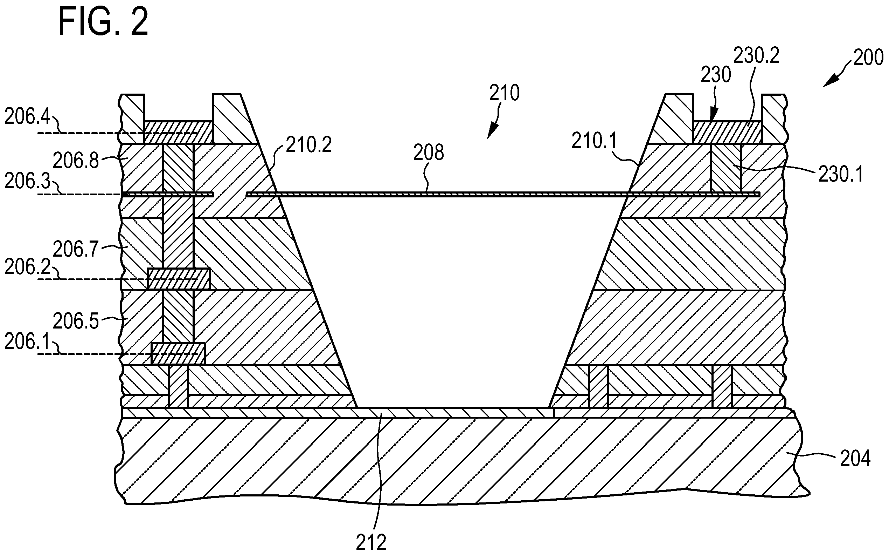

Eine mechanische Halterung und elektrische Kontaktierung des Aktuators 108 ist in der vorliegenden Querschnittsansicht nicht erkennbar. Dies wird anhand von Fig. 2 näher erläutert.

Der Aktuator 108 wird von einer Titannitrid-Schicht gebildet. Der Aktuator hat eine Dicke von 40 bis 100 nm, ist also deutlich dünner als eine typische Leitbahnschicht.

Im Mehrebenen-Leitbahnschichtstapel 106 ist um den Aktuator 108 herum eine Ausnehmung 110 ausgebildet. Die Ausnehmung reicht von der vierten Leitbahnebene 106.4 bis herunter zum Siliziumsubstrat 104. Im Bereich der Ausnehmung ist auf dem Siliziumsubstrat ein siliziertes hoch n-leitfähiges (n⁺-)Gebiet 112 ausgebildet, das die Grundplatte des Mikroviskosimeters bildet. Die Grundplatte ist in einem von flachen Isolationsgebieten 114 begrenzten aktiven Gebiet angeordnet. Geeignete Silizide zur Bildung der Grundplatte 112 sind beispielsweise Cobaltsilizid, Titansilizid und Platinsilizid. Die Grundplatte ist über mit Hilfe von Leitbahn- und Via-Strukturen gebildeten Kontakte 116 und 118 mit externen Schaltungsteilen verbunden. Via-Segmente wie beispielsweise das Via-Segment 116.1 befinden sich bekanntlich zwischen den Leitbahnebenen.

Ebenfalls dargestellt ist ein weiteres aktives Gebiet 118 im Siliziumsubstrat, in welchem ein MOS-Transistor 120 angeordnet ist. Der MOS-Transistor entspricht in seiner Struktur einem üblichen, mit CMOS-Technologie herstellbaren Transistor und ist in Fig. 1 beispielhaft, also stellvertretend für ein geeignetes aktives elektronisches Bauelement einer integrierten Schaltung dargestellt. Der MOS-Transistor 120 kann beispielsweise Teil einer integrierten Messvorrichtung sein, die ansonsten hier nicht näher dargestellt ist. Die Messeinrichtung dient im Mikroviskosimeter zur Messung der Zeitdauer bis zum Erreichen einer vorgegebenen Frequenzverstimmung nach dem Einschalten eines Oszillators, bezogen auf seine Startfrequenz - vgl. die Erläuterung der Funktionsweise des Mikroviskosimeters der DE 100 27 684 B4 im einleitenden Teil der vorliegenden Patentanmeldung.

Die Messvorrichtung kann in einer anderen Ausführungsform auch auf einem anderen Siliziumchip ausgebildet sein, der mit dem Mikroviskosimeter verbunden werden kann. Das Vorsehen zusätzlicher aktiver elektronischer Bauelemente auf dem Siliziumsubstrat 104 ist also keine notwendige Bedingung.

Die Funktionsweise des Mikroviskosimeters 100 der Fig. 1 entspricht der einleitend beschriebenen Funktionsweise des Mikroviskosimeters der DE 100 27 684 B4. Auf nähere Erläuterungen wird daher vorliegend verzichtet. Anzumerken ist, dass der Abstand des Aktuators 108 von der Grundplatte 112 durch eine Anordnung des Aktuators auf einer niedrigeren Leitbahnebene oder durch Anordnung der Grundplatte auf einer der Leitbahnebenen verändert werden kann.

Fig. 2 zeigt eine schematische Querschnittsansicht eines Ausführungsbeispiels eines Mikroviskosimeters 200 in einer senkrechten Querschnittsebene er Figur 1. Die Struktur des Mikroviskosimeters 200 der Fig. 2 gleicht in wesentlichen Aspekten der Struktur des Mikroviskosimeters 100 der Fig. 1. Aus diesem Grund sind einander entsprechende Strukturmerkmale der beiden Mikroviskosimeter 100 und 200 mit einander entsprechenden Bezugszeichen versehen, die sich allein in der ersten der jeweils drei Ziffern des betreffenden Bezugszeichens unterscheiden. Die nachfolgende Beschreibung konzentriert sich auf die in der hier dargestellten Schnittebene gegenüber Fig. 1 zusätzlich erkennbaren Strukturmerkmale des Mikroviskosimeters.

Die Aktuatorschicht 208 des Mikroviskosimeters 200 ist von einer Titannitrid-Schicht gebildet, die lokal das Standard-Leitbahnmaterial, beispielsweise Aluminium-Kupfer ersetzt. In einer weiteren, bevorzugten Ausführungsform sind auf der Leitbahnebene des Aktuators, jedoch außerhalb des lateralen Bereichs des Aktuators Leitbahnstrukturen angeordnet, die als eine von mehreren Materialschichten die Aktuator-schicht enthalten.

Die Titannitrid-Schicht des Aktuators 208 ist an Längsenden 210.1 und 210.2 der Ausnehmung 210 in die Schichtstruktur des Mehrebenen-Leitbahnschichtstapels 206 eingebettet. Im vorliegenden Fall ist der Aktuator zwischen die Zwischenebenen-Isolatorschichten zwischen der dritten und vierten Leitbahnebene 206.3 und 206.4 eingebettet. Die Zwischenebenen-Isolatorschichten werden mit Hilfe prozessüblicher Materialschichten gebildet. Geeignet sind beispielsweise PE-TEOS, SA-USG sowie SiON.

Am Lateralende 210.1 ist die Aktuatorschicht im Mehrebenen-Leitbahnschichtstapel 206 bis zu einem Kontakt 230 weitergeführt. Der Kontakt enthält eine Via-Struktur 230.1 und eine Leitbahnabschnitt 230.2.

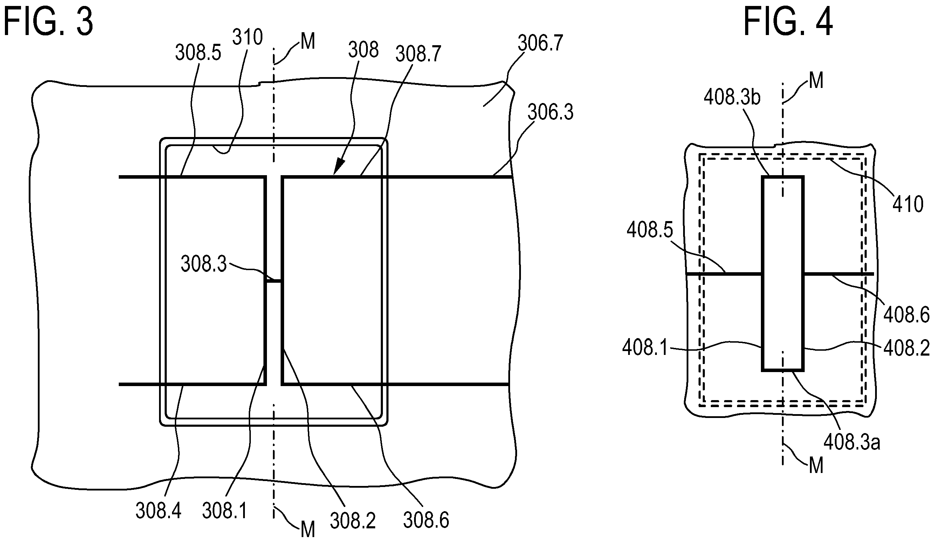

Nachfolgend Beispiele besonders geeigneter geometrischer Strukturen des Aktuators 108 bzw. 208 anhand unterschiedlicher Ausführungsbeispiele in den Fig. 3 und 4 beschrieben.

Fig. 3 zeigt eine Draufsicht einer Aktuatorstruktur 308 gemäß einem weiteren Ausführungsbeispiel der Erfindung. Der Aktuator 308 ist in einer Draufsicht dargestellt, in der die Ausnehmung 310 sowie die Fortführung der Aktuatorschicht 308 in der Leitbahnebene 306.3, eingebettet in einen Zwischenebenen-Isolator 306.7, erkennbar ist.

Der aus der TiN-Schicht hergestellte Aktuator 308 ist an wenigstens zwei gegenüberliegenden Stellen, im vorliegenden Ausführungsbeispiel an vier Stellen, die einander paarweise gegenüber liegen, am Rande des freigeätzten Bereiches fest im Zwischenebenenisolator verankert. Im Einzelnen ist der Aktuator 308 beidseitig der Ausnehmung 310 in den Mehrebenen-Leitbahnschichtstapel eingebettet und darin verankert.

Seine geometrische Struktur ist spiegelsymmetrisch bezüglich einer Mittelachse M der Ausnehmung 310. Die Mittelachse M ist zur Verbesserung der Lesbarkeit der Fig. 3 nur in Randbereichen des dargestellten Gebiets eingezeichnet. Zwei Leitbahnabschnitte 308.1 und 308.2 des Aktuators sind parallel zur Mittelachse M und in ihrer Nähe angeordnet und über einen Mittelsteg 308.3 miteinander verbunden. Die beiden Leitbahnabschnitte 308.1 und 308.2 haben also einen nur geringen Abstand voneinander. Diese senkrecht angeordneten Leitbahnabschnitte gewährleisten eine verbesserte Dehnbarkeit des Aktuators in Richtung der Verbindungslinie zwischen den Aufhängepunkten. Sie sind mit diesen jeweils über weitere Leitbahnabschnitte 308.4 und 308.5 bzw. 308.6 und 308.7 zum Rand der Ausnehmung 310 verbunden.

Der Mittelsteg verläuft senkrecht zur Mittelachse in der Leitbahnebene des Aktuators 308. Damit verläuft er zugleich parallel zu einer gedachten Verbindungslinie zwischen Aufhängepunkten des Aktuators 308 am Rand der Ausnehmung 310.

Die beschriebene Anordnung gewährleistet einerseits bei genügend dünner TiN-Schicht (besonders geeignet ist eine Dicke von 40 bis 100 nm) eine hinreichende Verbiegung bei einer HF-Spannung <1 V, verhindert aber andererseits ein unkontrolliertes Verbiegen der Aktuatorstruktur infolge mechanischer Spannungen innerhalb der dünnen TiN-Schicht. Die im Falle starker innerer Spannungen unvermeidlichen Verbiegungen von Teilen der beschriebenen Aktuatorstruktur senkrecht zur Metallebene bzw. zur Waferoberfläche führen bei geeigneter geometrischer Anordnung zu einer weiteren Verbesserung der Dehnbarkeit des Aktuators in Richtung der Verbindungslinie zwischen den Aufhängepunkten.

Fig. 4 zeigt eine schematische Draufsicht einer weiteren Aktuatorstruktur 408 nach einem anderen Ausführungsbeispiel der Erfindung. Die in Fig. 4 dargestellte Aktuatorform 408 erfüllt die gleichen Symmetrieeigenschaften wie die Aktuatorstruktur 308 der Fig. 3. Jedoch enthält die Aktuatorstruktur 408 anstelle eine Mittelsteges zwei Mittelstege 408.3a und 4083b, die die kurzen Seiten eines von achsenparallelen Leitbahnabschnitten 408.1 und 408.2 und den Mittelstegen umschlossenen Rechtecks bilden. Die achsenparallelen Leitbahnabschnitte sind im Unterschied zur Struktur der Fig. 3 jeweils nur über einen einzelnen senkrecht und mittig angreifenden Leitbahnabschnitt 408.5 bzw. 408.6 zum jeweils nächstliegenden Rand der Ausnehmung hin geführt.

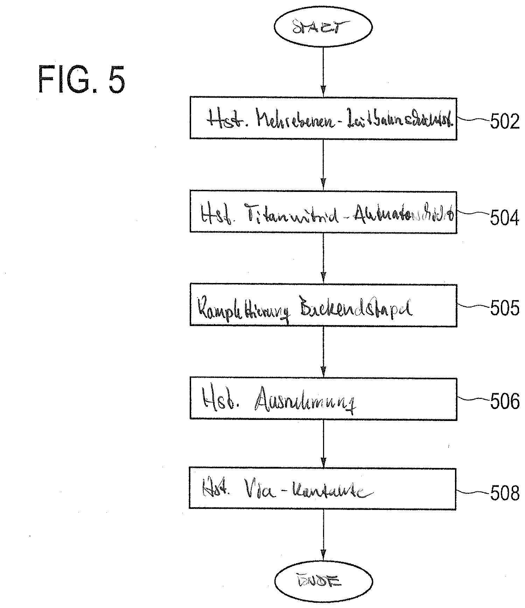

Fig. 5 zeigt ein Flussdiagramm eines Ausführungsbeispiels eines Herstellungsverfahrens für ein Mikroviskosimeter entsprechend den in Fig. 1 bis 4 gezeigten Beispielen.

Das Verfahren umfasst die folgenden Schritte:
Schritt 502: Herstellen eines Mehrebenen-Leitbahnschichtstapels bis zur Höhe einer für einen Aktuator vorgesehenen Leitbahnebene, wobei jeweilige Leitbahnebenen aus einem metallisch leitfähigen Leitbahnmaterial durch eine jeweilige Zwischenebenenisolatorschicht getrennt werden.

Für diesen Verfahrensschritt werden an sich bekannte Backend-Prozesse der CMOS- oder BiCMOS-Technologie eingesetzt. Im Rahmen der Abscheidung des Mehrebenen-Leitbahnschichtstapels wird die Grundplatte auf einer gewünschten Leitbahnebene hergestellt. Alternativ wird sie vor Herstellung des Leitbahnschichtstapels in einem aktiven Gebiet auf der Substratoberfläche hergestellt.

Schritt 504: Herstellen einer das Leitbahnmaterial der betreffenden Leitbahnebene zumindest lokal ersetzenden, metallisch leitfähigen, elastisch beweglichen und gegenüber korrosiven Flüssigkeiten beständigen Aktuatorschicht, die aus Titannitrid besteht.

Diese TiN-Schicht wird geeigneterweise zwischen der obersten und der darunter liegenden Standardleitbahnebene angeordnet und ist von denselben durch jeweils einen Zwischenebenenisolator getrennt und mit benachbarten Leitbahnebenen mittels standardmäßiger Vias verbunden.

Der Abstand zwischen Aktuator und Grundplatte kann bei Bedarf dadurch verringert bzw. optimiert werden, dass die TiN-Schicht zwischen zwei tieferliegenden Leitbahnebenen angeordnet wird, oder, wie in den Beispielen der Figuren 1 und 2, der Abstand zwischen Aktuator und Grundplatte sich über mehrere Leitbahnebenen erstreckt.

Der aus obiger TiN-Schicht hergestellte Aktuator wird durch nachfolgende Schichtabscheidung an wenigstens zwei gegenüberliegenden Stellen am Rande des freigeätzten Bereiches fest im Zwischenebenenisolatormaterial verankert.

Die Leitbahnebene, die den Aktuator enthält, weist in einem Ausführungsbeispiel ansonsten keine zusätzliche Leitbahnen auf. Dann erübrigt sich die Abscheidung weiterer Materialien für die zusätzlichen Leitbahnen, die aufgrund der Leitfähigkeitserfordernissen in der Regel aus anderen Materialien als Titannitrid gefertigt werden müssen. Titannitrid weist bekanntlich keine hohe Leitfähigkeit auf.

Das Leitbahnmaterial wird nur lokal im Bereich des Aktuators durch Titannitrid ersetzt. Der Schichtstapel der Leitbahnebene wird vor-zugsweise so gewählt, dass die später den Aktuator bildende Schicht oder Schichtfolge ein Bestandteil desselben ist.

Schritt 505: Komplettierung des Backendstapels bis einschließlich der Passivierung.

Schritt 506: Herstellen einer Ausnehmung im Mehrebenen-Leitbahnschichtstapel im Bereich der Aktuatorschicht, indem durch selektives isotropes nasschemisches Ätzen mit einem Ätzmittel mindestens eine Zwischenebenenisolatorschicht zwischen dem Aktuator und dem Substrat entfernt wird, derart, dass der Aktuator frei tragend wird.

Hierfür wird ein Ätzverfahren eingesetzt, welches hochselektiv zu im Backend verwendeten Metallen wie Aluminium, Wolfram, und Titannitrid sowie zu dem die Grundplatte bildenden Metallsilizid (Cobaltsilizid, Titansilizid, Platinsilizid) die im Backendprozess verwendeten Isolatorschichten isotrop entfernt.

Bei einer nasschemischen Ätzung der im Backend verwendeten mehrere µm starken Zwischenebenenisolatorschichten über strukturierten Fotolack (Fotolackmaske) ist die Ätzstabilität derselben von besonderer Bedeutung. Das wird erreicht durch die Verwendung eines speziellen ätzresistenten Fotolackes und durch eine Kombination gasförmiger und flüssiger Haftvermittler zur Erhöhung der Haftfestigkeit des Fotolackes.

Dazu wird vor der Belackung flüssiger Lackhaftvermittler aufgetragen und anschließend getempert. Unmittelbar vor der Lackbeschichtung erfolgt noch eine sogenannte Grundierung mittels eines Primers. Nach der Beschichtung mit Fotolack, dessen Dicke zwischen 4 und 6 µm variiert werden kann, wird eine weitere Temperung des gesamten Systems durchgeführt. Die Belichtung und Entwicklung des Fotolackes wird entsprechend seiner Dicke angepasst. In einem Sauerstoffplasma werden dann einige Nanometer des Fotolackes entfernt, um die Fenster im Fotolack zu säubern und die Lackkante an den Isolator anzufinieren.

Bevorzugt kommen für die Entfernung der Isolatorschichten über die Fotolackmaske nasschemische Ätzmittel zum Einsatz, beispielsweise ein Ätzmittel, das aus Ethylenglykol, Wasser, Ammoniumfluorid und Flusssäure besteht. Mittels dieses Ätzmittels ist es möglich, über die Fotolackmaske alle Isolatorschichten des CMOS- bzw. BiCMOS-Backends hochselektiv zu TiN oder anderen Metallen und Metalllegierungen, aus denen die Aktuator-Struktur des Mikroviskosimeters bestehen kann, isotrop zu entfernen. Das Ätzmittel stoppt dann hochselektiv auf dem Metallsilizid der Gegenelektrode (Grundplatte).

Die Ätzdauer wird in einem alternativen Ausführungsbeispiel so gewählt, dass Reste der Isolatorschichten unterhalb des Aktuators nicht entfernt werden, sondern bestehen bleiben. Auf diese Weise kann verhindert werden, dass im Betrieb des Mikroviskosimeters bei maximaler Auslenkung des Aktuators ein Kontakt mit der Grundplatte und damit ein Kurzschluss entsteht.

Nach Beendigung des Ätzprozesses spült man zur Entfernung des Ätzmittels mit deionisiertem Wasser. Danach wird die Fotolackmaske in Lösungsmitteln, z. B. in Aceton, entfernt.

Um beim anschließenden Trocknungsprozess einen sogenannten "Sticktion-Effekt" und damit eine plastische Verformung der Aktuator-Struktur zu vermeiden, muss verhindert werden, dass dieselbe durch die Oberflächenspannung des sich beim Trocknungsprozess verringernden Lösungsmittelvolumens in den geätzten Strukturen stark in Richtung Gegenelektrode verbogen wird.

Eine Methode ist, das Lösungsmittel zur Entfernung der Fotolackmaske durch ein anderes Lösungsmittel, das einen geringen Gefrierpunkt besitzt (z. B. Cyclohexan), zu verdrängen. Das Cyclohexan wird mittels Kühlung in den festen Aggregatzustand überführt und über einen Gefriertrocknungsprozess entfernt.

Eine weitere Methode ist, das Lösungsmittel zur Entfernung der Fotolackmaske mittels flüssigem Kohlendioxid zu entfernen, das Kohlendioxid durch Erhöhung der Temperatur über 32°C und des Druckes über 74 bar in einen superkritischen Zustand zu bringen und es entfernen, ohne dass die Aktuator-Struktur plastisch verformt wird.

Das Verfahren umfasst weiterhin (Schritt 508) das Kontaktieren des Aktuators durch Herstellen von Via-Kontakten mit darüber oder darunter angeordneten Leitbahnebenen, wobei das Herstellen der Via-Kontakte im Rahmen des Backend-Prozesses in geeigneter Weise vor oder nach dem Herstellen der Aktuatorschicht durchgeführt wird.

## Patentansprüche

1. MEMS-Bauelement (100), umfassend ein monolithisch integriertes elektronisches Bauelement (102) mit einem auf einem Substrat (104) angeordneten Mehrebenen-Leitbahnschichtstapel (106), in den ein frei tragender, elastisch beweglicher, metallischer Aktuator (108) integriert ist, der im Mehrebenen-Leitbahnschichtstapel (106) auf Höhe einer Leitbahnebene (106.3) angeordnet ist und durch Via-Kontakte (116.1, 230.1) mit darüber oder darunter angeordneten Leitbahnebenen (106.2, 106.4) verbunden ist, die abgesehen von einer Ausnehmung (110) im Bereich des Aktuators (108) durch eine jeweilige Zwischenebenenisolatorschicht (106.7, 106.8) von der Leitbahnebene (106.3) des Aktuators (108) getrennt sind, **dadurch gekennzeichnet, dass**
der Aktuator (108) aus einer metallisch leitfähigen und gegenüber korrosiven Flüssigkeiten oder Gasen beständigen Schicht gebildet ist, die aus Titannitrid besteht und die lokal das Standard-Leitbahnmaterial im Bereich des Aktuators (108) ersetzt,
eine korrosionsfesten und metallisch leitfähige Grundplatte (112) eine Gegenelektrode des Aktuators (108) bildet, und
der Aktuator (108) an wenigstens zwei einander gegenüberliegenden Aufhängepunkten (210.1, 210.2) am Rande der Ausnehmung (110) fest in der Zwischenebenenisolatorschicht (106.7, 106.8) verankert ist und eine spiegelsymmetrische Lateralstruktur mit wenigstens zwei zur Verbindungslinie zwischen den Aufhängepunkten (210.1, 210.2) senkrecht stehenden Leitbahnabschnitten (308.1, 308.2) in der Nähe einer Symmetrieachse (M) der Ausnehmung (110) besitzt, wobei die Leitbahnabschnitte (308.1, 308.2) durch mindestens einen Mittelsteg (308.3) des Aktuators (108) miteinander verbunden sind.

2. MEMS-Bauelement (100) nach Anspruch 1, bei dem die Grundplatte (112) von einem mit Titannitrid bedeckten Leitbahngebiet einer Leitbahnebene gebildet wird.

3. MEMS-Bauelement (100) nach Anspruch 1, bei dem das Substrat (104) ein Halbleitersubstrat ist und die Grundplatte (112) von einem mit einem Metallsilizid oder Titannitrid bedeckten aktiven Gebiet des Halbleitersubstrats gebildet wird.

4. MEMS-Bauelement (100) nach Anspruch 1, bei dem der Aktuator (108) von einer TiN-Schicht mit einer Dicke zwischen 40nm und 100nm gebildet wird.

5. MEMS-Bauelement (100) nach einem der vorstehenden Ansprüche, bei dem auf einem Abschnitt der Grundplatte (112) ein Zwischenebenen-Isolatorrest als Stopper für einen zu großen Ausschlag des Aktuators (108) angeordnet ist.

6. MEMS-Bauelement (100) nach einem der vorstehenden Ansprüche, bei dem auf der Leitbahnebene (106.3, 306.3) des Aktuators (108), jedoch außerhalb des lateralen Bereichs des Aktuators (108) Leitbahnstrukturen (106) angeordnet sind, die als eine von mehreren Materialschichten die Aktuatorschicht enthalten.

7. Mikroviskosimeter (200) mit einem MEMS-Bauelement (100) nach einem der vorstehenden Ansprüche.

8. Verfahren zur Herstellung eines MEMS-Bauelements (100) nach einem der vorstehenden Ansprüche, mit den Schritten
- Herstellen eines Mehrebenen-Leitbahnschichtstapels (106) auf einem Substrat (104) bis zur Höhe einer für einen Aktuator (108) vorgesehenen Leitbahnebene (106.3), wobei jeweilige Leitbahnebenen (106.2, 106.4) aus einem metallisch leitfähigen Leitbahnmaterial durch eine jeweilige Zwischenebenenisolatorschicht (106.7, 106.8) getrennt werden;
- Herstellen einer metallisch leitfähigen, elastisch beweglichen und gegenüber korrosiven Flüssigkeiten beständigen Aktuatorschicht, die aus Titannitrid besteht, auf der dafür vorgesehenen Leitbahnebene (106.3);
- Herstellen einer Ausnehmung (110) im Mehrebenen-Leitbahnschichtstapel (106) im Bereich der Aktuatorschicht, indem durch selektives isotropes nasschemisches Ätzen mit einem Ätzmittel mindestens eine Zwischenebenenisolatorschicht zwischen dem Aktuator (108) und dem Substrat (104) entfernt wird, derart, dass der Aktuator (108) frei tragend wird; und
- Kontaktieren des Aktuators (108) durch Herstellen von Via-Kontakten (116.1) mit darüber oder darunter angeordneten Leitbahnebenen (106.2, 106,.4), wobei das Herstellen der Via-Kontakte (116.1) vor oder nach dem Herstellen der Aktuatorschicht durchgeführt wird.

9. Verfahren nach Anspruch 8, bei dem beim Herstellen der Ausnehmung (110) die Entfernung der mindestens einen Zwischenebenenisolatorschicht unter Verwendung einer Fotolackmaske oder unter Verwendung einer Kombination einer Fotolackmaske mit einer Hartmaske erfolgt.

10. Verfahren nach Anspruch 9, bei dem die Fotolackmaske nach der Ätzung der mindestens einen Zwischenebenenisolatorschicht mittels polarer Lösungsmittel entfernt wird.

11. Verfahren nach Anspruch 10, bei dem die Lösungsmittel zur Entfernung der Fotolackmaske in einem Trocknungsprozess zur Verhinderung einer plastischen Verformung des Aktuators entweder durch Cyclohexan verdrängt werden, welches mittels Kühlung in den festen Aggregatzustand überführt und über einen Gefriertrocknungsprozess entfernt wird oder mittels flüssigem Kohlendioxid entfernt werden, wobei das Kohlendioxid in einen superkritischen Zustand gebracht wird.

12. Verfahren nach Anspruch 8, bei dem das Herstellen der Ausnehmung (110) im Mehrebenen-Leitbahnschichtstapel (106) erst nach einer Komplettierung des Mehrebenen-Leitbahnschichtstapels (106) bis einschließlich einer Herstellung einer Passivierungsschicht einer höchsten Leitbahnebene erfolgt.

## Claims

1. MEMS component (100), comprising a monolithically integrated electronic component (102) having a multi-plane conductor track stack (106) disposed on a substrate (104), into which a cantilevered, resiliently movable, metallic actuator (108) is integrated, which is disposed on the multi-plane conductor track stack (106) at the level of a conductor track plane (106.3) and is connected by via contacts (116.1, 230.1) with conductor track planes (106.2, 106.4) arranged above or below the conductor track plane (106.3), which are separated by a respective intermediate insulator layer (106.7, 106.8), apart from a recess (110) in the area of the actuator (108), from the conductor track plane (106.3) of the actuator (108), **characterised in that**
the actuator (108) is made of a layer that is metallic-conductive and resistant to corrosive liquids or gases and that consists of titanium nitride and that locally replaces the standard conducting track material in the area of the actuator (108),
a corrosion-resistant and metallic-conductive base plate (112) forms a counterelectrode of the actuator (108), and
the actuator (108) is firmly anchored in the intermediate plane insulator layer (106.7, 106.8) at at least two opposite suspension points (210.1, 210.2) at the edge of the recess (110), and has a mirror-symmetrical lateral structure with at least two conductor track sections (308.1, 308.2), perpendicular to the connecting line between the suspension points (210.1, 210.2), in the vicinity of a symmetry axis (M) of the recess (110), wherein the conductor track sections (308.1, 308.2) are connected to one another by at least a middle web (308.3) of the actuator (108).

2. MEMS component (100) according to claim 1, in which the base plate (112) is formed by a conductor track area of a conductor track plane covered with titanium nitride.

3. The MEMS component (100) of claim 1, wherein said substrate (104) is a semiconductor substrate and said base plate (112) is formed by an active region of said semiconductor substrate covered with a metal silicide or titanium nitride.

4. The MEMS component (100) according to claim 1, wherein said actuator (108) is formed by a TiN layer having a thickness between 40 nm and 100 nm.

5. MEMS component (100) according to one of the preceding claims, in which an intermediate insulator rest is disposed as a stopper for a too-large deflection of the actuator (108) on a section of the base plate (112).

6. MEMS component (100) according to one of the preceding claims, in which on the conductor track plane (106.3, 306.3) of the actuator (108), but outside the lateral area of the actuator (108), conductor track structures (106) are arranged, which contain the actuator layer as one of a plurality of material layers.

7. Microviscosimeter (200) comprising a MEMS component (100) according to one of the preceding claims.

8. A method of manufacturing a MEMS component (100) according to one of the preceding claims, comprising the steps
- producing a multiplane conductor layer stack (106) on a substrate (104) up to the height of a conductor track plane (106.3) provided for an actuator (108), wherein respective conductor track planes (106.2, 106.4) of a metallic conductive conductor track material are separated by a respective intermediate plane insulator layer (106.7, 106.8);
- producing a metallic conductive actuator layer, which is resiliently movable and resistant to corrosive liquids, consisting of titanium nitride on the conductor track plane (106.3) provided for this purpose;
- producing a recess (110) in the multiplane conductor layer stack (106) in the area of the actuator layer by removing at least one intermediate plane insulating layer between the actuator (108) and the substrate (104) by selective isotropic wet-chemical etching with an etchant such that the actuator (108) is cantilevered; and
- contacting the actuator (108) by establishing via contacts (116.1) with conductor track planes (106.2, 106.4) arranged above or below, wherein via contacts (116.1) are produced before or after producing the actuator layer.

9. Method according to claim 8, in which whilst producing the recess (110), the removal of at least one intermediate plane insulator layer takes place by using a photo-resist mask or by using a combination of a photo-resist mask with a hard mask.

10. Method according to claim 9, in which the photo-resist mask is removed by means of polar solvents after etching at least one intermediate plane insulator layer.

11. Method according to claim 10, in which the solvents for removing the photo-resist mask in a drying process to prevent plastic deformation of the actuator are either displaced by cyclohexane that is cooled to solid state by means of refrigeration and removed by a freeze-drying process or removed by means of liquid carbon dioxide, where the carbon dioxide is brought into a supercritical state.

12. Method according to claim 8, in which the production of the recess (110) in the multi-plane conductor layer stack (106) takes place only after completion of the multi-plane conductor layer stack (106) up to and including a passivation layer of the highest conductor track plane.

## Revendications

1. Composant MEMS (100), comprenant un composant (102) électronique à intégration monolithique avec un empilement de couches à pistes conductrices multiniveau (106), disposé sur un substrat (104), dans lequel est intégré un actionneur (108) métallique en porte-à-faux à mobilité élastique qui est disposé dans l'empilement de couches à pistes conductrices multiniveau (106) à la hauteur d'un niveau de pistes conductrices (106.3) et qui est, par des contacts par trou d'interconnexion (116.1, 230.1), raccordé à des niveaux de pistes conductrices (106.2, 106.4) disposés au-dessus ou au-dessous qui, à l'exception d'un creux (110) dans la zone de l'actionneur (108), sont séparés du niveau de pistes conductrices (106.3) de l'actionneur (108) par une couche isolante inter-niveau (106.7, 106.8) respective, **caractérisé en ce que**
l'actionneur (108) est formé d'une couche conductrice métallique et résistante aux liquides ou gaz corrosifs qui est composée de nitrure de titane et remplace localement le matériau de pistes conductrices standards dans la zone de l'actionneur (108),
une plaque de base (112) conductrice métallique et résistante à la corrosion forme une contre-électrode de l'actionneur (108), et
l'actionneur (108) est ancré fixement dans la couche isolante inter-niveau (106.7, 106.8) sur au moins deux points de suspension (210.1, 210.2) opposés sur le bord du creux (110) et possède une structure latérale à symétrie spéculaire avec au moins deux tronçons de pistes conductrices (308.1, 308.2) perpendiculaires à la ligne de raccordement entre les points de suspension (210.1, 210.2) à proximité d'un axe de symétrie (M) du creux (110), les tronçons de pistes conductrices (308.1, 308.2) étant raccordés l'un à l'autre par au moins une barrette centrale (308.3) de l'actionneur (108).

2. Composant MEMS (100) selon la revendication 1, dans lequel la plaque de base (112) est formée par un secteur de pistes conductrices d'un niveau de pistes conductrices revêtu de nitrure de titane.

3. Composant MEMS (100) selon la revendication 1, dans lequel le substrat (104) est un substrat à semi-conducteurs et la plaque de base (112) est formée par un secteur actif du substrat à semi-conducteurs revêtu de siliciure métallique ou de nitrure de titane.

4. Composant MEMS (100) selon la revendication 1, dans lequel l'actionneur (108) est formé par une couche TiN d'une épaisseur comprise entre 40 nm et 100 nm.

5. Composant MEMS (100) selon l'une des revendications précédentes, dans lequel, sur un tronçon de la plaque de base (112), il est disposé un reliquat isolant inter-niveau en tant qu'arrêt pour une excursion trop importante de l'actionneur (108).

6. Composant MEMS (100) selon l'une des revendications précédentes, dans lequel, sur le niveau de pistes conductrices (106.3, 306.3) de l'actionneur (108), mais à l'extérieur de la zone latérale de l'actionneur (108), il est disposé des structures de pistes conductrices (106) qui contiennent la couche d'actionneur en tant que couche parmi plusieurs couches de matériau.

7. Micro-viscosimètre (200) avec un composant MEMS (100) selon l'une des revendications précédentes.

8. Procédé de fabrication d'un composant MEMS (100) selon l'une des revendications précédentes, avec les étapes
- fabrication d'un empilement de couches à pistes conductrices multiniveau (106) sur un substrat (104) jusqu'à la hauteur d'un niveau de pistes conductrices (106.3) prévu pour un actionneur (108), des niveaux de pistes conductrices (106.2, 106.4) respectifs en matériau de pistes conductrices conducteur métallique étant séparés par une couche isolante inter-niveau (106.7, 106.8) respective ;
- fabrication d'une couche d'actionneur conductrice métallique, à mobilité élastique et résistante aux liquides corrosifs, qui est composée de nitrure de titane, sur le niveau de pistes conductrices (106.3) prévu pour cela ;
- fabrication d'un creux (110) dans l'empilement de couches à pistes conductrices multiniveau (106) dans la zone de la couche d'actionneur par le fait que, par un décapage par voie chimique humide isotrope sélectif avec un agent décapant, au moins une couche isolante inter-niveau est enlevée entre l'actionneur (108) et le substrat (104), de telle sorte que l'actionneur (108) est en porte-à-faux ; et
- mise en contact de l'actionneur (108) par la fabrication de contacts par trou d'interconnexion (116.1) avec des niveaux de pistes conductrices (106.2, 106.4) disposés au-dessus ou au-dessous, la fabrication des contacts par trou d'interconnexion (116.1) étant réalisée avant ou après la fabrication de la couche d'actionneur.

9. Procédé selon la revendication 8, dans lequel, lors de la fabrication du creux (110), l'enlèvement de la couche isolante inter-niveau au moins au nombre de un s'effectue avec l'utilisation d'un masque de photoréserve ou avec l'utilisation d'une combinaison d'un masque de photoréserve avec un masque dur.

10. Procédé selon la revendication 9, dans lequel le masque de photoréserve est enlevé au moyen de solvants polaires après le décapage de la couche isolante inter-niveau au moins au nombre de un.

11. Procédé selon la revendication 10, dans lequel les solvants destinés à l'enlèvement du masque de photoréserve sont, dans un processus de séchage, pour empêcher une déformation plastique de l'actionneur, soit chassés par du cyclohexane qui est amené dans l'état d'agrégat solide au moyen d'un refroidissement et est enlevé par le biais d'un processus de séchage par congélation, soit enlevés au moyen de dioxyde de carbone liquide, le dioxyde de carbone étant amené dans un état supercritique.

12. Procédé selon la revendication 8, dans lequel la fabrication du creux (110) dans l'empilement de couches à pistes conductrices multiniveau (106) ne s'effectue qu'après une finalisation de l'empilement de couches à pistes conductrices multiniveau (106) jusqu'à y compris une fabrication d'une couche de passivation d'un niveau de pistes conductrices le plus élevé.
